## Europäisches Patentamt

## European Patent Office

## Office européen des brevets

(19)

(11) Publication number: **0 024 094**
**B1**

# EUROPEAN PATENT SPECIFICATION

(45) Date of publication of patent specification: **12.06.85**

(51) Int. Cl.⁴: **H 01 L 21/318**

(21) Application number: **79900242.3**

(22) Date of filing: **19.02.79**

(86) International application number:
**PCT/JP79/00040**

(87) International publication number:
**WO 80/01740 21.08.80 Gazette 80/19**

## (54) METHOD OF PRODUCING SEMICONDUCTOR DEVICES.

(43) Date of publication of application:
**25.02.81 Bulletin 81/08**

(45) Publication of the grant of the patent:
**12.06.85 Bulletin 85/24**

(84) Designated Contracting States:
**DE FR GB**

(56) References cited:
**JP-A-54 019 663**
**JP-A-54 021 264**
**JP-A-54 023 472**

**Journal of the Electrochemical Society, vol. 125, no. 3, (1978-3), T. Ito, et al (very thin), Silicon nitride films growth by direct thermal reaction with nitrogen), p. 448-452**

**Journal of the Electrochemical Society, vol. 125, no. 11, (1978-11), D. Hackleman et al., (A simple technique for silicon nitride growth), p. 1875-1876**

(73) Proprietor: **FUJITSU LIMITED**
**1015, Kamikodanaka Nakahara-ku**
**Kawasaki-shi Kanagawa 211 (JP)**

(72) Inventor: **NOZAKI, Takao**
**3754-13, Aza Muta, Hirasa-cho, Sendai-shi**
**Kagoshima-985 (JP)**
Inventor: **ITO, Takashi**
**408, Noborito Tama-ku**
**Kawasaki-shi Kanagawa 214 (JP)**
Inventor: **SHINODA, Masaichi**
**14-10, Yoshinodai 2-chome**
**Sagamihara-shi Kanagawa 229 (JP)**

(74) Representative: **Muir, Ian R. et al**
**HASELTINE LAKE & CO. Hazlitt House 28**
**Southampton Buildings Chancery Lane**
**London WC2A 1AT (GB)**

Courier Press, Leamington Spa, England.

## Description

This invention relates to a method of manufacturing a semi-conductor device wherein a nitride film is produced on a silicon substrate, for example for forming the gate insulating film of an insulated gate FET or an insulating film for stabilizing the semi-conductor surface.

Conventionally, the basic structure of a semi-conductor device known as an insulated gate FET or MISFET is composed of semi-conductor substrate, an insulating film which covers the surface of said substrate and metallic electrodes provided on the surface of the insulating film. Usually, the semi-conductor substrate is silicon (Si), the insulating film is silicon dioxide $SiO_2$, generated by thermal oxidation, and the metallic electrodes are aluminium (Al). However, a device having such a structure has a disadvantage that when an electric field of $10^6$ V/cm is applied across the metallic electrode and substrate at 200°C, there is a large variation in the gate threshold voltage at which the conductive channel is formed. This phenomenon is believed to be caused by variation in the space charge distribution at the interface because of the existence of trapping levels of carrier due to structural defects of the $SiO_2$ and drift of impurity ions contained in the $SiO_2$. It is natural that such variation of space charge is most distinctive at the interface of Si and $SiO_2$ because charges are induced at the Si surface by electro-static induction.

Previously, in order to reduce such instability, various techniques have been employed, for example, vitrification of the $SiO_2$ surface, multiplication of the layers of $SiO_2$ and other insulating films such as $Al_2O_3$ and $Si_3N_4$, oxidation in an ambient atmosphere including HCl, and also oxidation of Si in an ultra-clean ambient atmosphere. However, an essential improvement of the interface structure of the Si and $SiO_2$ has so far still not been proposed.

This invention seeks to provide a method of forming a semi-conductor surface film which is particularly effective for solving the instability of the MIS structure and, moreover, for passivating the surface of a wide variety of semi-conductors. Conventionally, as an alternative insulating film to $SiO_2$ formed at the surface by direct reaction with the Si substrate, $Si_3N_4$ is considered. It is well known that $Si_3N_4$ is more dense than $SiO_2$ and does not easily allow mixture of ions such as those of sodium although it wholly depends upon the generation condition.

However, in a film generation process by direct thermal reaction between the Si substrate and ammonia gas, since the formation rate is rate-determined by the diffusion velocity of N in the $Si_3N_4$ which is formed when a very thin film is formed, it has proved difficult to obtain homogeneous amorphous $Si_3N_4$ at the surface of Si.

Specifically, since an $SiO_2$ film having a thickness of 20 Å or more on the Si substrate makes diffusion of N difficult, it is difficult to obtain an ideal $Si_3N_4$ film.

An $Si_3N_4$ film obtained by direct thermal reaction with the Si substrate has been proposed using ammonia gas as the reaction gas and formed at a reaction temperature within the range from 1100 to 1200°C.

Conventionally, in the case where ammonia gas is used as the reaction gas, since ammonia gas is poisonous, the gas in the reaction tube is replaced by an inert gas, such as Ar or He, when the Si substrate is inserted or removed from the reaction tube which has previously been heated up to a reaction temperature as high as 1200°C. Namely, the ambient gas in the reaction tube heated previously up to the predetermined reaction temperature is replaced by such an inert gas, the Si substrate is then inserted in the tube, the ammonia gas as the reaction gas is then supplied to form the desired $Si_3N_4$ film, thereafter the ammonia gas is replaced with an inert gas or nitrogen gas and the Si substrate then removed.

It has been found by the inventors that if, for example, after the ambient gas in the reaction tube is replaced with He or Ar gas, which substantially does not include oxidative impurities such as $H_2O$ and $O_2$ etc. exceeding 1 ppm, the Si substrate is inserted and arranged in the reaction tube and then ammonia gas used as the reaction gas is introduced, then during the period of about 1 minute taken for the replacement of the ambient gas by the ammonia gas, an oxide film having a thickness of 20 to 25 Å is formed on the Si substrate surface.

For this reason it is difficult to produce a satisfactory nitride film even when ammonia gas is used as the reaction gas.

Alternatively, in the case of direct thermal nitriding using nitrogen gas as the reaction gas, it is generally difficult to obtain high purity nitrogen gas. When nitrogen gas including $H_2O$ of 1 ppm and $O_2$ of 0.1 ppm, a nitride film having a thickness of 30 to 40 Å with a refraction index of 2.1 to 3.8 is formed with a reaction time of about 1 minute at 1200°C. But it is considered to be an $Si_3N_4$ film including much Si because the refraction index is large, and this also causes some problems.

According to the present invention there is provided a method of manufacturing a semi-conductor device wherein an amorphous nitride film is produced on a silicon substrate within a reaction tube containing an ambient atmosphere of ammonia gas or a mixed gas including ammonia and an inert gas, characterised in that the silicon substrate for nitriding is inserted into the reaction tube at a location having in operation a reduced temperature relative to the reaction area with a nitrogen or inert gas ambient atmosphere in the tube, in that this atmosphere is replaced by an ammonia gas or a mixed gas including ammonia, and in that said silicon substrate is moved to the reaction area of the tube which is preheated to the reaction temperature to start direct thermal nitriding of the silicon surface in said ammonia gas or mixed gas at the reaction temperature.

This invention offers a method where $O_2$ and $H_2O$ which oxidate Si are blocked to facilitate the obtaining of a homogeneous amorphous $Si_3N_4$ film on the Si substrate by direct thermal reaction with ammonia.

For a better understanding of the present invention reference will now be made, by way of example, to the accompanying drawings in which:

Fig. 1 shows in diagrammatic form apparatus for carrying out this invention, and

Fig. 2 shows a cross-section through the structure of a gate insulating film for an MISFET.

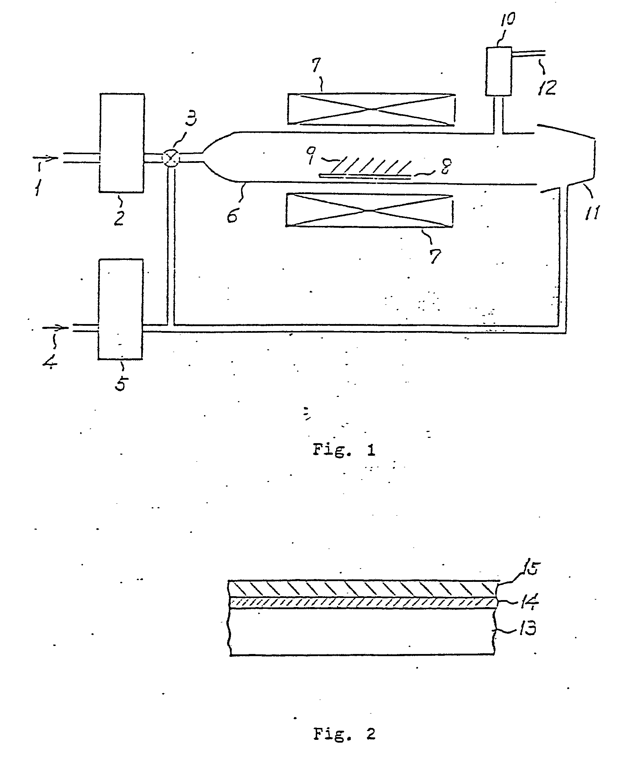

Fig. 1 shows one embodiment of an apparatus for carrying out the present invention. In this figure, 1 is ammonia gas; 2 is an ammonia gas refining system of a catalytic kind; 3 is a valve; 4 is nitrogen gas; 5 is a nitrogen gas refining system of a catalytic kind; 6 is a reaction tube made of quartz, silicon carbide or silicon; 7 is an electric furnace; 8 is a wafer board; 9 is an Si substrate wafer; 10 is a rotary pump; 11 is a jig made of quartz for forming a gas curtain with the nitrogen gas; and 12 is a gas exhaust port.

After the natural oxide film on the surface of the Si substrates 9 is reduced to several Å by chemical treatment, they are mounted in the board 8 and positioned at the inlet port of the reaction tube 6 through which nitrogen gas is flowing via the valve 3. The inlet port of said reaction tube is set to a normal temperature. Thereafter, the nitrogen gas is replaced with the ammonia gas by switching the valve 3 to receive gas from the refining system 2 and the rotary pump 10 is then immediately operated. However, nitrogen gas is always sent to the quartz jig 11 at the rate of 10 to 30 l/min, thus forming a nitrogen gas curtain at the open end of tube 6 thereby preventing direct flow of the ammonia gas out of the tube.

When the reaction tube is filled with the ammonia gas after a certain period, the wafer board 8 is moved into the high temperature area of the reaction tube. The high temperature area and the gas therein are preheated up to a reaction temperature as high as 1200°C.

After a predetermined reaction period, the wafer board 8 is moved to said inlet port of the reaction tube 6. Then, after confirming that the Si substrates 9 have cooled to room temperature, the ammonia gas is replaced with nitrogen gas by operating the valve 3 and the ammonia gas is exhausted from the reaction tube. Thereafter, the rotary pump 10 is stopped.

With a reaction time of 30 minutes at a substrate temperature of 1200°C, a satisfactory $Si_3N_4$ film with a thickness of about 50 Å and a refraction index of 1.8 to 2.0 can be obtained.

In the above-mentioned embodiment an inert gas may be used in place of the nitrogen gas.

Also, if the ammonia gas used above as the reaction gas is replaced with a mixed gas of ammonia gas and an inert gas, a satisfactory $Si_3N_4$ film can also be formed.

As explained above, the amount of growth is restricted to around 100 Å because the diffusion rate of reactive nitrogen atoms is rate-determining.

For this reason, in order to use such a nitride film for the gate insulation film of a MISFET, the nitride film 14 having a thickness of several tens of Å is formed by the above method on a semiconductor substrate 13 as shown in Fig. 2, then an insulating film 15 such as $SiO_2$, $Si_3N_4$, $Al_2O_3$ or $Ta_2O_3$ is laminated thereon to achieve the desired thickness. Such a structure gives a semi-conductor device having very stable electrical characteristics because the Si surface is covered with a very dense $Si_3N_4$ film.

From the above it can be seen, therefore, that using the method according to this invention, an insulating film which particularly excels as a protective film for the semi-conductor surface can be obtained and a stabilized semi-conductor surface can be attained thereby. Especially is this invention effective when adopted to produce a gate insulating film for a field effect transistor since for such devices the achievement of satisfactory surface characteristics is a serious problem.

## Claims

1. A method of manufacturing a semi-conductor device wherein an amorphous nitride film (14) is produced on a silicon substrate (9, 13) within a reaction tube (6) containing an ambient atmosphere of ammonia gas or a mixed gas including ammonia and an inert gas, characterised in that the silicon substrate (9, 13) for nitriding is first inserted into the reaction tube (6) at a location having in operation a reduced temperature relative to the reaction area with a nitrogen or inert gas ambient atmosphere in the tube (6), in that this atmosphere is replaced by an ammonia gas or a mixed gas (1) including ammonia, and in that said silicon substrate is then moved to the reaction area of the tube which is preheated to the reaction temperature to start direct thermal nitriding of the silicon surface in said ammonia gas or mixed gas (1) at the reaction temperature.

2. A method of manufacturing a semi-conductor device according to claim 1 wherein the said location is an inlet port of the reaction tube.

3. A method of manufacturing a semi-conductor device according to claim 1 or 2 wherein the nitride film (14) is formed to a thickness of several tens of Å and whereafter a further film of $SiO_2$, $Al_2O_3$ (15) is produced over said nitride film to provide a desired total combined insulating film thickness.

## Patentansprüche

1. Verfahren zur Herstellung einer Halbleitervorrichtung, bei welchem ein amorpher Nitridfilm (14) auf einem Siliziumsubstrat (9, 13) innerhalb eines Reaktionsrohres (6) hergestellt wird, welches eine Umgebungsatmosphäre aus Ammoniak oder einem gemischten Gas enthält, welches Ammoniakgas und ein inertes Gas umfaßt, dadurch gekennzeichnet, daß das Siliziumsubstrat (9, 13) zum Nitrieren zuerst in das Reaktionsrohr (6) an eine Stelle eingeführt wird, welche im Betrieb eine reduzierte Temperatur relativ zu dem Reaktionsbereich hat, mit einer Umgebungsatmosphäre aus Stickstoff oder inertem Gas in dem Rohr (6), daß diese Atmosphäre durch ein Ammoniakgas oder ein gemischtes Gas (1), welches Ammoniak enthält, ersetzt wird, und daß das genannte Siliziumsubstrat dann zu dem Reaktionsbereich in dem Rohr bewegt wird, welcher auf die Reaktionstemperatur vorgewärmt ist, um eine direkte thermische Nitrierung der Siliziumoberfläche in dem genannten Ammoniakgas oder dem gemischten Gas (1) bei der Reaktionstemperatur zu starten.

2. Verfahren zur Herstellung einer Halbleiter-Vorrichtung nach Anspruch 1, bei welchem die genannte Stelle eine Einlaßöffnung des Reaktionsrohres ist.

3. Verfahren zur Herstellung einer Halbleiter-Vorrichtung nach Anspruch 1 oder 2, bei welchem der Nitridfilm (14) mit einer Dicke von mehreren Å gebildet wird und daraufhin ein weiterer Film aus $SiO_2$ oder $Al_2O_3$ (15) über dem genannten Nitridfilm erzeugt wird, um eine gewünschte Gesamtdicke des kombinierten Isolationsfilms zu bilden.

**Revendications**

1. Procédé de fabrication d'un dispositif semiconducteur où une pellicule de nitrure amorphe (14) est produite sur un substrat de silicium (9, 13) à l'intérieur d'un tube de réaction (6) contenant une atmosphère ambiante d'ammoniac gazeux ou un gaz mélange comportant de l'ammoniac et un gaz inerte, caractérisé en ce que l'on insère d'abord le substrat de silicium (9, 13) destiné à la nitruration dans le tube de réaction (6) en un emplacement qui présente, en fonctionnement, une température réduite par rapport à la zone de réaction, sous une atmosphère ambiante d'azote ou de gaz inerte dans le tube (6), en ce que l'on remplace cette atmosphère par de l'ammoniac gazeux ou un gaz mélangé (1) comportant de l'ammoniac et en ce que l'on déplace ensuite ledit substrat de silicium jusqu'à la zone de réaction du tube, laquelle a été préchauffée à la température de réaction, pour faire commencer la nitruration thermique directe de la surface de silicium dans l'ammoniac gazeux ou le gaz mélangé (1) à la température de réaction.

2. Procédé de fabrication d'un dispositif semiconducteur selon la revendication 1, où ledit emplacement est un orifice d'entrée du tube de réaction.

3. Procédé de fabrication d'un dispositif semiconducteur selon la revendication 1 ou 2, où la pellicule de nitrure (14) est formée à une épaisseur de plusieurs dizaines d'angströms et où on applique une autre pellicule (15) en $SiO_2$, $Al_2O_3$ au-dessus de ladite pellicule de nitrure afin d'obtenir une épaisseur combinée totale voulue de pellicule isolante.

Fig. 1

Fig. 2